# EUROPEAN PATENT APPLICATION

(11) **EP 4 312 018 A1**
(43) Date of publication of application: **31.01.2024**
(21) Application number: 23185241.9
(22) Date of filing: 13.07.2023
(51) Int. Cl.: G01N 21/88, G01N 21/956

(54) **MOUNTING DEVICE AND METHOD OF MANUFACTURING SEMICONDUCTOR DEVICE**

(30) Priority: 27.07.2022 JP 2022119131; 15.09.2022 JP 2022146800
(71) Applicant: Fasford Technology Co., Ltd., Yamanashi 400-0212 (JP)
(72) Inventor: KOBASHI, Hideharu, Yamanashi, 400-0212 (JP); YAMAMOTO, Keita, Yamanashi, 400-0212 (JP); MATSUZOE, Akio, Japan, 400-0212 (JP)
(74) Representative: Strehl Schübel-Hopf & Partner

(57) **Abstract**

A mounting device includes at least paired mirrors disposed to face with each other, an imaging device disposed so that a die and a reflection surface of the mirror are positioned in the field of view, an illumination device for irradiating illumination light along an optical axis of the imaging device, and a blurring suppressing unit for suppressing blurring generated on an outline of a side surface of the die by a part of the light reflected by the reflection surface of one of the paired mirrors, which has passed through a periphery of the die.

## Description

### Technical Field

The present disclosure relates to a mounting device, which is applicable to a die bonder for inspecting a side surface of a die, for example.

### Background Art

A mounting device such as a die bonder is configured to attach (mount) an element onto a substrate or an element using a bonding material. For example, a resin or a solder, which is liquified or film-shaped is used as the bonding material. The element includes a semiconductor chip, a MEMS (Micro Electro Mechanical System), a die such as a glass chip, or an electronic component. The substrate includes a wiring substrate, a lead frame as a sheet metal, and a glass substrate.

For example, the die bonder is operated positioning the element or performing the side surface inspection of the element based on an image taken by the camera (for example, Patent Literature 1).

### Citation List

### Patent Literature

PTL 1: Japanese Unexamined Patent Application Publication No. 2014-179558 Technical Problem

An object of the present disclosure is to provide technology which ensures improvement in accuracy of abnormality inspection of the side surface of the element. Other problems and new characteristics will be clarified from description of the specification and attached drawings.

### Solution to Problem

Summary of the representative example of the disclosure is described as below.

That is, the mounting device includes at least one set of paired mirrors disposed to face with each other, an imaging device disposed to have a die and a reflection surface of at least one of the paired mirrors positioned in a field of view, an illumination device for irradiating illumination light along an optical axis of the imaging device, and a blurring suppressing unit for suppressing blurring generated on an outline of a side surface of the die by a part of the light reflected by the reflection surface of one of the paired mirrors, which has passed through a periphery of the die.

### Advantageous Effects of Invention

The disclosure allows improvement in accuracy of the abnormality inspection of the side surface of the element.

### Brief Description of Drawings

Fig. 1 is a schematic top view of a die bonder according to a first embodiment.
Fig. 2 is a schematic side view of the die bonder as shown in Fig. 1.
Fig. 3 is a flowchart representing a method of manufacturing a semiconductor device using the die bonder as shown in Fig. 1.
Fig. 4 schematically shows a stage recognition camera, a coaxial illumination, and an intermediate stage according to the first embodiment.
Fig. 5 schematically shows a coaxial illumination light around the intermediate stage according to a comparative example.
Fig. 6 shows an image of a side surface of a die using the coaxial illumination light as shown in Fig. 5.
Fig. 7 shows an image of a side surface of a die in ideal illumination.
Fig. 8 shows the intermediate stage according to an example of the first embodiment.
Fig. 9 shows the intermediate stage according to another example of the first embodiment.
Fig. 10 shows three kinds of photographed images of the die at different angles of reflection surface of a mirror.
Fig. 11 shows a structure of the intermediate stage and an optical path of transmitted light according to a first modification of the first embodiment.
Fig. 12 is a top view of the intermediate stage as shown in Fig. 11.
Fig. 13 shows the optical path of reflected light around the intermediate stage as shown in Fig. 11.
Fig. 14 shows a stage recognition camera, an illumination device, and an intermediate stage according to a second modification of the first embodiment.
Fig. 15 is an explanatory view of an irradiation region of a plane emission type lighting as shown in Fig. 14.
Fig. 16 is a view of irradiation regions for irradiating illumination light of the plane emission type lighting as shown in Fig. 15.
Fig. 17 is an explanatory view of irradiation regions of the plane emission type lighting according to a third modification of the first embodiment.
Fig. 18 is a view of irradiation regions for irradiating illumination light of the plane emission type lighting as shown in Fig. 17.
Fig. 19 shows a stage recognition camera, an illumination device, and an intermediate stage of a die bonder according to a second embodiment.
Fig. 20 is a conceptual diagram explaining direct photographing on the intermediate stage as shown in Fig. 19.
Fig. 21 is a view of an exemplified image photographed by the structure as shown in Fig. 19.
Fig. 22 is a flowchart representing the surface inspection process for recognizing a foreign substance or a flaw, which has been distinguished.
Fig. 23 shows a stage recognition camera, an illumination device, and an intermediate stage according to a first modification of the second embodiment.
Fig. 24 is a view of an exemplified image photographed by the structure as shown in Fig. 23.
Fig. 25 is a view of another exemplified image photographed by the structure as shown in Fig. 23.
Fig. 26 is a flowchart representing the surface inspection process according to a third modification of the second embodiment for recognizing a foreign substance or a flaw, which has been distinguished.

### Description of Embodiments

Embodiments and modifications are described referring to the drawings. In the description, the same components are followed by the same reference signs so that repetitive explanations are omittable. In the drawings, each width, thickness, or shape of the elements is schematically depicted, which may differ from the size of the actual configuration for clarity of the description. The dimensional relationship among the respective elements is not necessarily in proper proportion to one another in the drawings.

### [First Embodiment]

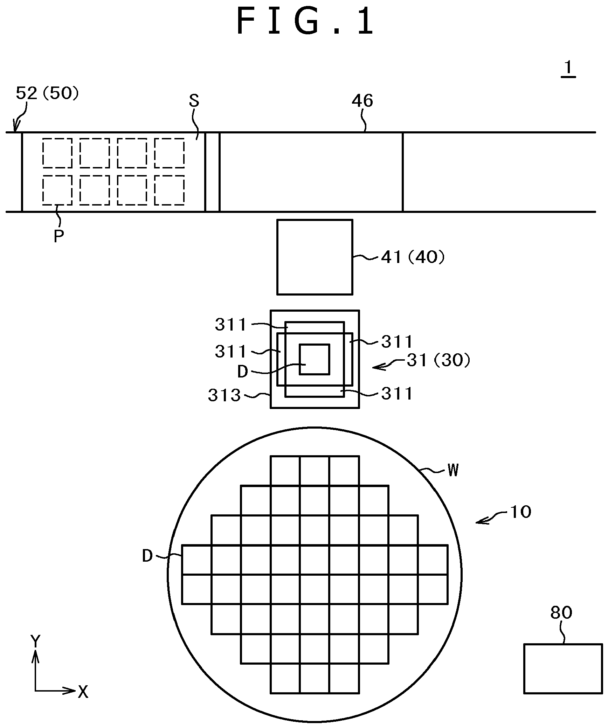

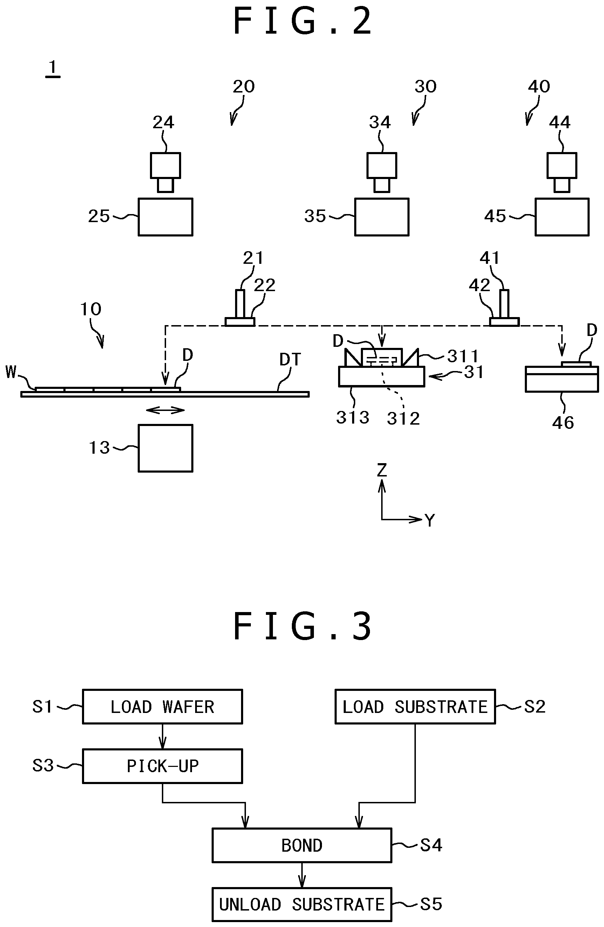

Referring to Figs. 1 and 2, a die bonder structure according to a first embodiment is described. Fig. 1 is a schematic top view of the die bonder according to a first embodiment. Fig. 2 is a schematic side view of the die bonder as shown in Fig. 1.

A die bonder 1 mainly includes a die supply section 10, a pick-up section 20, an intermediate stage section 30, a bonding section 40, a transporting section 50, and a control section (controller) 80 for monitoring and controlling operations of the respective components. A Y-axis direction and an X-axis direction correspond to the front-rear direction and the left-right direction of the die bonder 1, respectively. The die supply section 10 is placed to the front of the die bonder 1, and the bonding section 40 is placed to the rear of the die bonder 1.

The die supply section 10 includes a wafer holder (not shown) for holding a wafer W, and a release unit 13 for releasing a die D from the wafer W. The wafer holder is moved in the XY direction by a not shown drive unit, and the die D to be picked up is moved to the position of the release unit 13. The release unit 13 is moved in the up-down direction by a not shown drive unit. The wafer W is adhered onto a dicing tape DT, and divided into multiple dies D. The dicing tape DT to which the wafer W adheres is held by a not shown wafer ring. A film-like adhesive material called a die attach film (DAF) is applied between the wafer W and the dicing tape DT. The die attach film is cured by heating.

The pick-up section 20 includes a pick-up head 21, a wafer recognition camera 24, and an illumination device 25. The pick-up head 21 includes a collet 22 having a tip onto which the die D is adsorbed and held. The pick-up head 21 picks up the die D from the die supply section 10, and mounts the die on the intermediate stage 31. The wafer recognition camera 24 grasps a pick-up position of the die D to be picked up from the wafer W. The pick-up section 20 includes units for driving the pick-up head to be moved up/down, rotated, and moved in X and Y directions, respectively.

The intermediate stage section 30 includes an intermediate stage 31, a stage recognition camera 34, and an illumination device 35. The intermediate stage 31 includes mirrors 311a to 311d, a stand 312 on which the die D is temporarily mounted, and a base 313. The mirrors 311a to 311d may be collectively called a mirror 311. The stage recognition camera 34 is provided above the intermediate stage 31 for photographing the die D on the intermediate stage 31. The illumination device 35 is a coaxial illumination to be placed between the stage recognition camera 34 and the intermediate stage 31.

Each of four mirrors 311 has an oblique reflection surface at a predetermined angle to an optical axis of the stage recognition camera 34, and placed on the base 313. The number of mirrors 311 is not limited to four, but may be two when recognizing only two specific side surfaces of the die D. The mirror 311 which faces one side surface of the die D may be constituted by multiple mirrors.

The mirror 311 is shaped into a triangular prism which has opposite side surfaces each shaped as an isosceles triangle, and each of other side surfaces, a bottom surface, and a slope having a reflection surface shaped as a rectangle. In other words, the reflection surface has a planar shape. The mirror 311 may be constituted by a prism in place of a mirror.

The predetermined angle is set so that the side surface of the die D is irradiated with the illumination light from the illumination device 35 at a nearly vertical angle to the side surface of the die D, and imaging of the side surface of the die D is enabled at a nearly vertical angle. The image of the side surface of the die D is reflected by the reflection surface of the mirror 311 to allow the stage recognition camera 34 above the intermediate stage 31 to image and inspect the upper surface and four side surfaces of the die D simultaneously (single exposure).

The die D is temporarily mounted on the stand 312. A mount surface of the stand 312, on which the die D is mounted is higher than the surface (upper surface of the base 313) on which the mirror 311 is placed. The stand 312 may be formed into a columnar shape, having its mount surface as the upper surface smaller than the die D. In the case where the die D is adsorbed onto the mount surface, the mount surface is sized to prevent bending and deformation of an outer peripheral end of the die D. This makes it possible to place the mirror 311 near the die D, and to attain easy photographing of the lower end of the die D. Furthermore, the stand is adaptable to change in the size of the die to be mounted. Accordingly, although it is preferable to provide the stand 312, it does not have to be provided.

The stage recognition camera 34 is provided just above the intermediate stage 31, and has the viewing angle vertically directed downward so that the center axis of the intermediate stage 31 is aligned with the optical axis of the stage recognition camera 34. The stage recognition camera 34 is placed so that the die D and each reflection surface of four mirrors 311 are positioned in the field of view. The illumination device 35 irradiates light to attain brightness sufficient to allow the stage recognition camera 34 to photograph the die D mounted on the intermediate stage 31. The reflected light which has been irradiated is incident on the four mirrors 311. The structure allows the stage recognition camera 34 to photograph the die D from its side surfaces to the upper surface.

An optical image which is made incident on the four mirrors 311 is further made incident along the optical axis of the stage recognition camera 34 provided above the four mirrors 311. The stage recognition camera 34 photographs object images reflected from the upper surface of the die D and the four mirrors 311. Images photographed by the stage recognition camera 34 are output to the control section 80, and processed. Those images can be displayed on a display screen (not shown).

The bonding section 40 includes a bond head 41, a substrate recognition camera 44, an illumination device 45, and a bond stage 46. Like the pick-up head 21, the bond head 41 includes a collet 42 having a tip onto which the die D is adsorbed and held. The substrate recognition camera 44 images a position recognition mark (not shown) of a substrate S so that a bond position is recognized. The substrate S has multiple product areas to be grouped into one package in the end (hereinafter referred to as a package area P). The position recognition mark is provided for each package area P. When mounting the die D on the substrate S, the bond stage 46 is moved upward to support the substrate S from below. The bond stage 46 includes a suction port (not shown) for performing vacuum adsorption of the substrate S so that the substrate S can be fixed. The bond stage 46 includes a heating section (not shown) for heating the substrate S. The bonding section 40 includes units for driving the bond head 41 to be moved up and down, rotated, and moved in X and Y directions, respectively.

The structure allows the bond head 41 to correct a pick-up position/posture based on the data imaged by the stage recognition camera 34 so that the die D is picked up from the intermediate stage 31. The bond head 41 bonds the die onto the package area P of the substrate S based on the imaged data, or bonds the die to be stacked onto the die which has been already bonded to the package area P of the substrate S.

The transporting section 50 includes a transporting lane 52. The transporting lane 52 transports the substrate S in the X-axis direction. The structure allows the substrate S to move from a not shown substrate supply section up to the bond position (mount position) along the transporting lane 52. After bonding, the transporting lane moves to a not shown substrate unloading section, or returns to the substrate supply section.

The control section 80 includes a memory which stores the program (software) for monitoring and controlling operations of the respective components of the die bonder 1 as described above, and a central processing unit (CPU) for executing the program stored in the memory.

Referring to Fig. 3, an explanation is made about a bond process (manufacturing method) as one of process steps of manufacturing a semiconductor device using the die bonder 1. Fig. 3 is a flowchart representing a method of manufacturing the semiconductor device using the die bonder as shown in Fig. 1. As described below, operations of the respective components constituting the die bonder 1 are controlled by the control section 80.

### (Wafer loading step : step S1)

Wafer ring (not shown) is supplied to a wafer cassette (not shown) of the die bonder 1. The supplied wafer ring is fed to the die supply section 10, and loaded to the die bonder 1. The wafer ring holds a dicing tape DT to which the die D divided from the wafer W is attached.

### (Substrate loading step : step S2)

A substrate transporting jig which stores the substrate S is supplied to the substrate supply section, and loaded to the die bonder 1. The substrate S is taken from the substrate transporting jig by the substrate supply section, and fixed to a not shown transporting claw.

### (Pick-up step : step S3)

After execution of step S1, the wafer holder is moved to pick up the target die D from the dicing tape DT. The die D is photographed by the wafer recognition camera 24 for positioning and surface inspection of the die D based on the photographed image data.

The release unit 13 and the pick-up head 21 release the positioned die D from the dicing tape DT. The die D released from the dicing tape DT is adsorbed and held by the collet 22 of the pick-up head 21, and then transported and mounted onto the intermediate stage 31.

The stage recognition camera 34 photographs the die D on the intermediate stage 31. Based on the photographed image data, positioning and surface inspection of the die D are conducted. The image data are processed to calculate a deviation amount (directions of X, Y, θ) of the die D on the intermediate stage 31 from a die position reference point of the die bonder for positioning. The die position reference point is preliminarily held as an initially set predetermined position of the intermediate stage 31. The surface inspection of the die D is conducted by processing the image data.

The pick-up head 21 which has transported the die D to the intermediate stage 31 is returned to the die supply section 10. Following the procedure as described above, the next die D is released from the dicing tape DT. The die D will be released from the dicing tape DT one by one in accordance with the similar procedure.

### (Bonding step : step 4)

The transporting section 50 transports the substrate S to the bond stage 46. The substrate recognition camera 44 takes an image of the substrate S mounted on the bond stage 46, and image data are obtained by photographing. The image data are processed to calculate a deviation amount (directions of X, Y, θ) of the substrate S from a substrate position reference point of the die bonder 1. The substrate position reference point is preliminarily held as an initially set predetermined position of the bonding section 40.

Based on the deviation amount of the die D on the intermediate stage 31, which has been calculated in step S3, an adsorbing position of the bond head 41 is corrected so that the die D is adsorbed by the collet 42. The bond head 41 which has adsorbed the die D from the intermediate stage 31 bonds the die D to a predetermined position of the substrate S supported by the bond stage 46. The predetermined position of the substrate S represents the package area P of the substrate S, a region where an element is additionally bonded to the already mounted element, or a bond region where the element is stacked and bonded. The substrate recognition camera 44 photographs the die D which has been bonded to the substrate S. Based on the photographed image data, an inspection is conducted whether the die D has been bonded to a desired position. If the inspected die D is defective, the bond head 41 transports the defective die to a dump area.

The bond head 41 which has bonded the die D to the substrate S is returned to the intermediate stage 31. Following the procedure as described above, the next die D is picked up from the intermediate stage 31, and bonded to the substrate S. Each of dies D will be bonded to a predetermined position of the substrate S by implementing the similar procedure repeatedly.

### (Substrate unloading step : step S5)

The substrate S to which the die D is bonded is transported to a substrate unloading section. The substrate S is taken from the substrate transporting claw in the substrate unloading section, and stored in the substrate transporting jig. The substrate S stored in the substrate transporting jig is unloaded from the die bonder 1.

As described above, the die D is mounted on the substrate S, and unloaded from the die bonder 1. Thereafter, the transporting jig which stores the substrate S on which the die D is mounted is transported to the wire bonding step. In the step, an electrode of the die D is electrically connected to an electrode of the substrate S via an Au wire or the like. The substrate S is transported to the mold step in which the die D and the Au wire are sealed with a mold resin (not shown) to complete fabrication of the semiconductor package.

The stack bonding process is executed as described below. Subsequent to the wire bonding step, the transporting jig which stores the substrate S having the die D mounted thereon is loaded to the die bonder. The die D is stacked onto the die D which has been mounted on the substrate S. After unloading from the die bonder, the die is electrically connected to the electrode of the substrate S via the Au wire in the wire bonding step. The die D stacked on the second or higher layers is released from the dicing tape DT by implementing the above-described method, and transported to the bonding section so that it is stacked on the die D. After repeating execution of the step the predetermined number of times, the substrate S is transported to the molding step. Multiple dies D and the Au wire are sealed with a mold resin (not shown) to complete fabrication of the stack package.

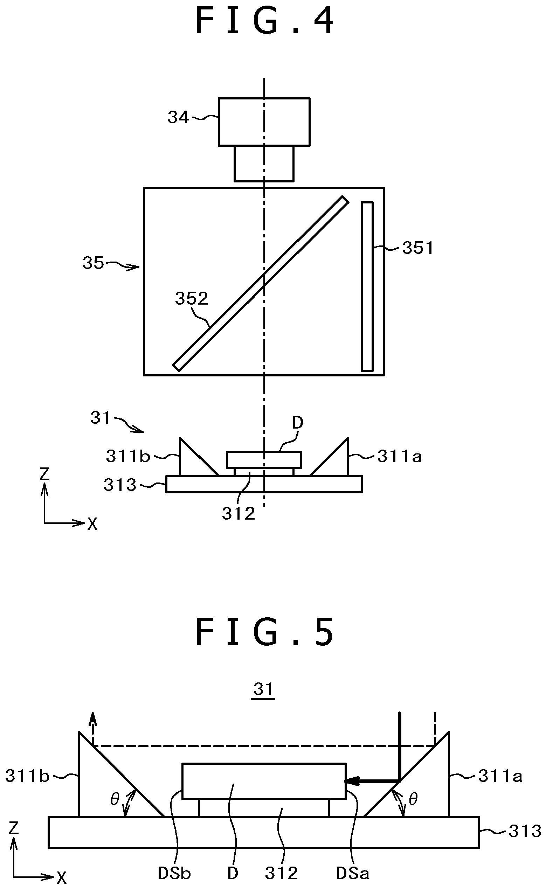

The illumination device 35 is described hereinafter. Fig. 4 schematically shows the stage recognition camera, the coaxial illumination, and the intermediate stage according to the embodiment.

Referring to Fig. 4, the illumination device 35 is placed between the stage recognition camera 34 and the intermediate stage 31. The illumination device 35 includes a plane emission type lighting (light source) 351 and a half mirror (semi-transmissive mirror, beam splitter) 352. Light irradiated from the plane emission type lighting 351 is reflected by the half mirror 352 to the optical axis direction which is the same as that of the stage recognition camera 34 to irradiate the die D on the intermediate stage 31. The light which irradiates the die D along the same optical axis as that of the stage recognition camera 34 is reflected by the die D. The resultant reflected light transmits through the half mirror 352, and reaches the stage recognition camera 34 to form an image of the die D. The illumination device 35 is formed as a coaxial episcopic illumination (coaxial illumination) device.

The mirror 331 having the oblique reflection surface at approximately 45° to the optical axis of the stage recognition camera 34 is placed on the intermediate stage 31. The light of the coaxial illumination (coaxial illumination light) is reflected by the mirror 311. The reflected illumination light is further reflected by the side surface of the die D substantially vertically. The light reflected by the side surface of the die D is reflected by the mirror 311 to reach the stage recognition camera 34. That is, four side surfaces of the die D can be illuminated and photographed substantially vertically.

Referring to Figs. 5 to 7, the problem of the side surface imaging is described for clarifying the first embodiment.

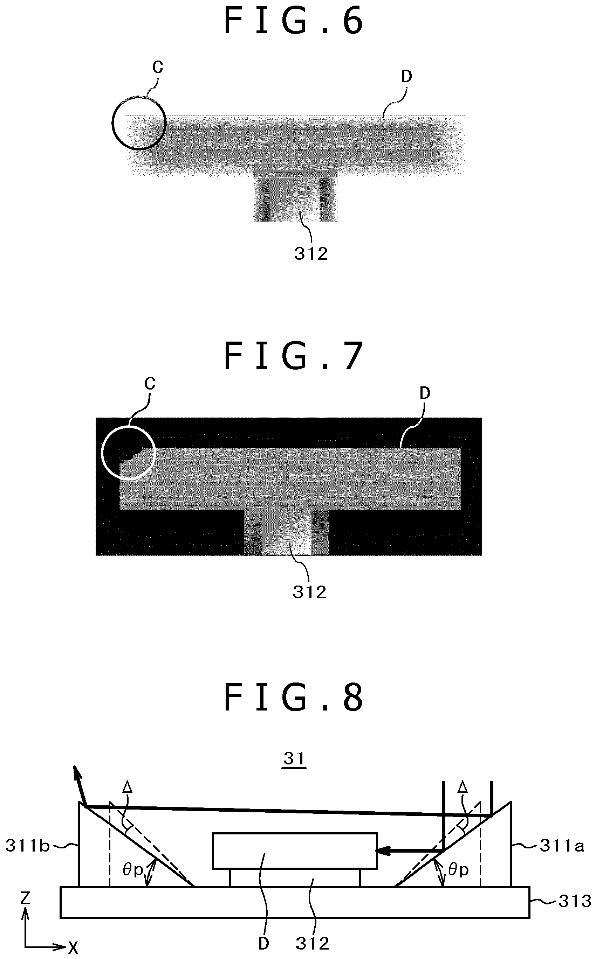

Fig. 5 schematically shows the coaxial illumination light around the intermediate stage according to a comparative example. Fig. 6 shows an image of the side surface of the die using the coaxial illumination light as shown in Fig. 5. Fig. 7 shows an image of the side surface of the die in ideal illumination.

Referring to Fig. 5, it is assumed that a slope (θ) of each reflection surface of the mirrors 311a, 311b is set to 45° to the upper surface of the base 313 of the intermediate stage 31. The light indicated by a dotted line as a part of the coaxial illumination light reflected by the mirror 311a passes through a periphery of the die D, and impinges on the reflection surface of the opposing mirror 311b horizontally without impinging on a side surface DSa of the die D. The light which has not impinged on the side surface DSa of the die D is partially reflected by the reflection surface of the mirror 311b at 45° again, and proceeds toward the stage recognition camera 34. The upper surface of the base 313 is perpendicular to the optical axis of the stage recognition camera 34.

The light which has not impinged on the side surface DSa of the die D partially serves as surrounding light (transmitted light or backlighting) to brighten the periphery when observing the side surface DSb opposite to the side surface DSa. If light with sufficient intensity serves as the surrounding light upon photographing for obtaining a clear image of the surface (side surface) of the die D, the surrounding light becomes brighter than the light reflected by the surface (side surface) of the die D in proportion to several inverse times the reflection factor, resulting in the state of excess light intensity.

When photographing in this state, the light surrounds an outline of the die D as shown in Fig. 6 to make the outline part blurring. The side surface inspection of the die D is conducted to check for chipping which occurs upon dicing as well as the flaw and the foreign substance of the side surface. The chipping mainly occurs around the outline part of the side surface of the die. Once the surrounding light causes blurring of the outline, it is difficult to detect the fine chipping. A chipping in a circle C as shown in Fig. 6 cannot be easily recognized. When detecting the chipping in the coaxial illumination, it is preferable to make the outline part of the side surface of the die D visible with uniform brightness as shown in Fig. 7. In this state, the chipping as a recess portion in the circle C may be photographed as a dark section.

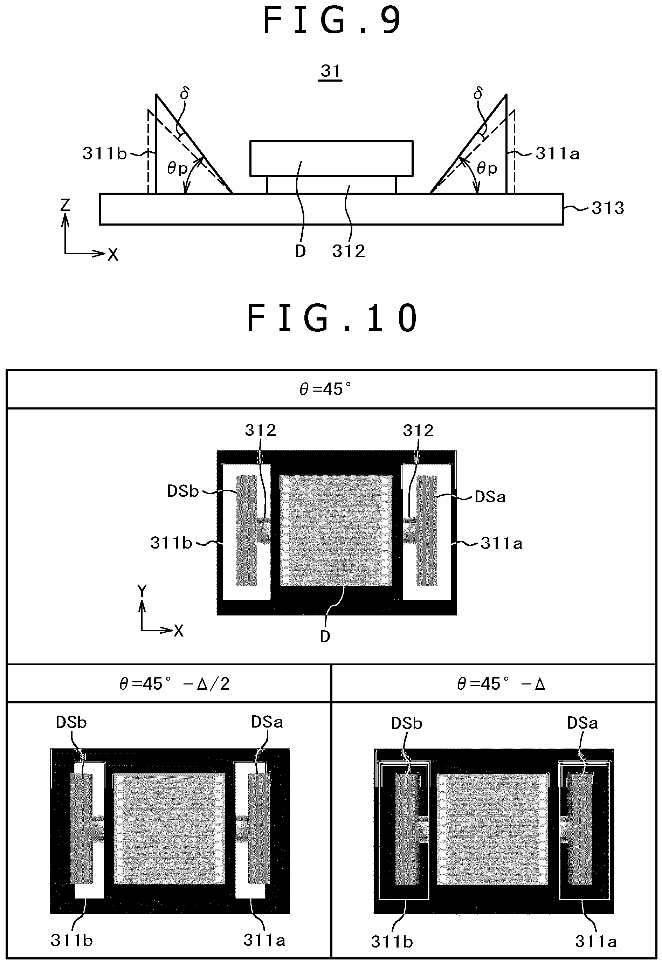

Referring to Figs. 8 and 9, a structure of the intermediate stage according to the first embodiment is described. Fig. 8 shows the intermediate stage according to an example of the first embodiment. Fig. 9 shows the intermediate stage according to another example of the first embodiment.

Referring to the intermediate stage 31 according to the first embodiment as shown in Fig. 8, the slope (θ) of the reflection surface of the mirror 311 is set to a predetermined angle (θp), that is, the slope (θ) of the reflection surface is slightly displaced from 45° (for example, θp = 45°- Δ). The displacement angle is defined as Δ. The light which has been reflected by the mirror 311 twice, and directed toward the stage recognition camera 34 causes "the slope four times larger than the displacement angle (Δ) of the mirror 311 to 45°". Accordingly, such light cannot be taken by the stage recognition camera 34. The slope of the mirror 311 to the optical axis of the reflection surface is expressed as (90°- θ). The predetermined angle to the optical axis is expressed as (45° + Δ).

As Fig. 9 shows, the slope of the reflection surface of the mirror 311 may be displaced from 45° in an opposite direction to the one as shown in Fig. 9 (θp = 45° + δ). The angle may be set so that the light emitting surface of the coaxial illumination becomes invisible, which is behind the image of the opposite mirror.

Referring to Fig. 10, an explanation is made about a picked-up image obtained when the slope (θ) of the reflection surface is decreased from 45° as shown in Fig. 8. Fig. 10 shows three kinds of photographed images of the die at different angles of reflection surface of the mirror. As Fig. 10 shows, only a pair of mirrors 311a, 311b which face with each other are provided as the mirrors 311. The image shows an upper surface and two side surfaces DSa, DSb of the die D, and two side surfaces of the stand 312.

If each slope (θ) of reflection surfaces of the mirrors 31 1a, 311b is 45°(θ = 45°), the mirrors 311a, 311b which face with each other appear white except the part hidden by the die D.

If each slope (θ) of reflection surfaces of the mirrors 31 1a, 311b is inclined by the angle smaller than an appropriate angle from 45° (θ = 45°- Δ/2), the mirrors 311a, 311b which face with each other appear white except the upper part of the die D, and the part hidden by the die D.

If each slope (θ) of reflection surfaces of the mirrors 311a, 311b is inclined appropriately from 45°(θ = 45°- Δ = θp), the side surface of the die D is shown, but the mirrors 311a, 311b which face with each other are not shown (appear black).

As the slope of the reflection surface of the mirror 311 is decreased, the opposing mirrors no longer appear. In this state, as the die D is obliquely shown, the bottom surface of the die D is slightly observed.

An "inter-mirror distance", that is, the distance between the opposing mirrors 311a and 311b is larger than a "distance between the mirror and the side surface", that is, each distance between the mirrors 311a, 311b, and the opposing side surfaces of the die D. Gradual decrease in the slope of the reflection surface of the mirror 311 makes the opposing mirrors invisible while keeping the side surfaces of the die visible. In other words, the predetermined angle (θp) is set to allow photographing of the side surface of the die D, and to prevent the light passing around the die D from reaching the stage recognition camera 34. The slope of the reflection surface of the mirror 311 serves to suppress the surrounding light. Such measure for suppressing the surrounding light serves to prevent blurring of the outline generated on the side surface of the die D, which has been caused by the light passing around the die D.

The first embodiment provides one or more advantageous effects as described below.
(1) It is possible to suppress blurring generated on the outline of the side surface of the die in the image, which has been caused by the light surrounding the die.
(2) It is possible to stabilize accuracy, and further increase accuracy in detection of chipping on the side surface of the die.
(3) It is possible to improve accuracy and yield of the product to be assembled by the die bonder.

### <Modification of the first embodiment>

Representative modifications of the first embodiment are described. In the description of the modification, structures and functions of the components, which are similar to those described in the first embodiment are followed by the similar reference signs. Description of those components allows citation of the corresponding components described in the first embodiment appropriately so long as they are mutually technically consistent. The above-described embodiment and multiple modifications may be partially or entirely applied multifunctionally so long as they are mutually technically consistent.

### (First modification)

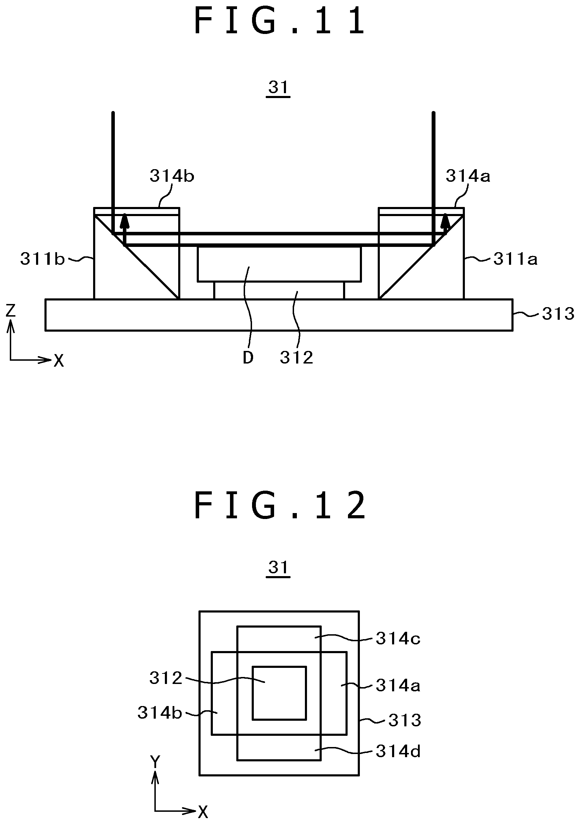

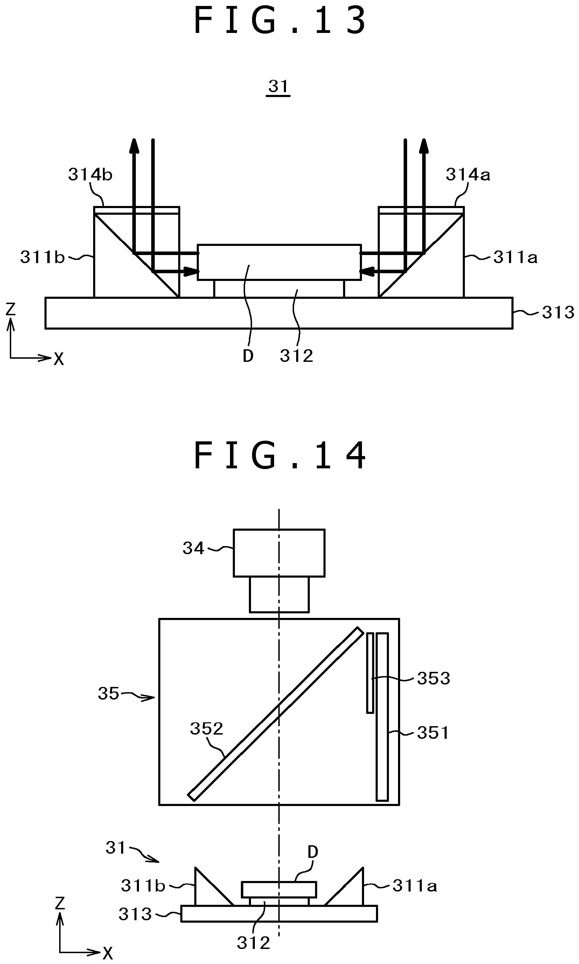

An intermediate stage 31 according to a first modification is described referring to Figs. 11 to 13. Fig. 11 shows a structure of the intermediate stage and an optical path of transmitted light according to the first modification of the first embodiment. Fig. 12 is a top view of the intermediate stage as shown in Fig. 11. Fig. 13 shows an optical path of reflected light around the intermediate stage as shown in Fig. 11.

Referring to Fig. 11, compared with the embodiment, the intermediate stage 31 of the first modification further includes polarized filters 314a to 314d. The polarized filters 314a to 314d are horizontally placed on the mirrors 311a to 311d, respectively. The polarized filters 314a to 314d may be collectively called a polarized filter 314. Each of opposing polarized filters 314 has different polarizing direction by 90°. It is preferable to use non-polarizing mirrors 311.

Referring to Fig. 11, as the polarizing direction of the polarized filter 314a is different from that of the polarized filter 314b by 90°, the transmitted light which has passed through the polarized filter 314a, and the mirrors 311a, 311b cannot pass through the polarized filter 314b. Correspondingly, the transmitted light which has passed through the polarized filter 314b, and the mirrors 311b, 311a cannot pass through the polarized filter 314a. That is, illumination light cannot pass through both the polarized filters 314a and 314b. This makes it possible to prevent the light surrounding the die D from generating blurring on the outline of the side surface of the die in the image. The polarized filter 314 serves as means to suppress the surrounding light.

Referring to Fig. 13, the light reflected by the right side surface of the die D after passing through the polarized filter 314a and the mirror 311a is allowed to pass through the polarized filter 314a via the mirror 311a. Correspondingly, the light reflected by the left side surface of the die D after passing through the polarized filter 314b and the mirror 311b is allowed to pass through the polarized filter 314b via the mirror 311b.

Preferably, the mirror 311 is constituted by a prism to allow easy attachment of the polarized filter 314.

### (Second modification)

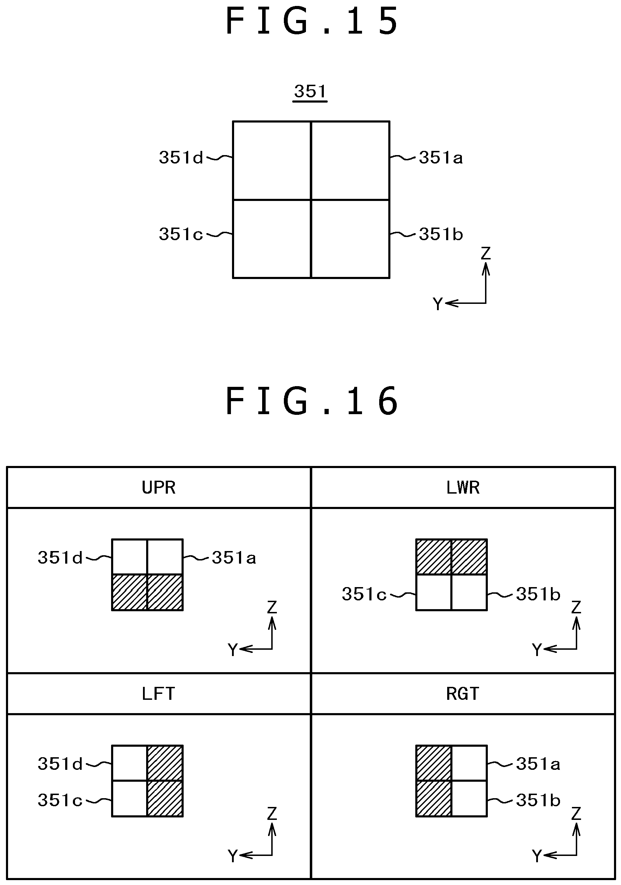

An illumination device 35 according to a second modification is described referring to Figs. 14 to 16. Fig. 14 shows a stage recognition camera, an illumination device, and an intermediate stage according to the second modification of the first embodiment. Fig. 15 is an explanatory view of an irradiation region of a plane emission type lighting as shown in Fig. 14. Fig. 16 is a view of irradiation regions for irradiating illumination light of the plane emission type lighting as shown in Fig. 15.

The intermediate stage 31 of the second modification has the similar structure to that of the intermediate stage of the comparative example as shown in Fig. 5. The stage recognition camera 34 of the second modification has the similar structure to the one described in the embodiment. Except a shielding plate, the illumination device 35 of the second modification has the similar structure to that of the illumination device 35 of the embodiment.

The irradiation region of the plane emission type lighting 351 is divided for each side surface of the die D to be photographed. As Fig. 15 shows, the irradiation region of the plane emission type lighting 351 is divided into four square regions. Only two adjacent irradiation regions among the four regions 351a to 351d irradiate the die D with illumination light. As Fig. 16 shows, the regions for irradiating the illumination light are selected from the regions 351a to 351d.

The region for irradiating the illumination light is selected from the regions 351a to 351d by moving a shielding plate 353 provided at the side of a half mirror 352 of the plane emission type lighting 351. In this case, the shielding plate 353 serves as means to suppress irradiation. The plane emission type lighting 351 may be constituted by arrayed LEDs so that the irradiation region is selected by lighting on/off of the LED. Alternatively, the irradiation region may be selected by lighting on/off of the display device constituting the plane emission type lighting 351 such as the liquid crystal display, and organic EL (Electro Luminescence) display. The light-off region of the plane emission type lighting 351 serves as means to suppress irradiation. The irradiation suppressing unit serves as means to suppress blurring generated on the outline of the side surface of the die D, which is caused by the light passing around the die D.

When photographing the side surface of the die D opposite to the mirror 311a, the side surface is irradiated with illumination light from the regions 351a, 351d as indicated by UPR of Fig. 16.

When photographing the side surface of the die D opposite to the mirror 311b, the side surface is irradiated with illumination light from the regions 351b, 351c as indicated by LWR of Fig. 16.

When photographing the side surface of the die D opposite to the mirror 311c, the side surface is irradiated with illumination light from the regions 351c, 351d as indicated by LFT of Fig. 16.

When photographing the side surface of the die D opposite to the mirror 311d, the side surface is irradiated with illumination light from the regions 351a, 351b as indicated by RGT of Fig. 16.

The four side surfaces of the die D are photographed four times. All the regions 351a to 351d irradiate the upper surface of the die D with illumination light for photographing.

### (Third modification)

In the second modification, the irradiation region of the plane emission type lighting 351 is equally divided into four regions. The divided regions 351a to 351d are not necessarily obtained by equally dividing the irradiation region so long as a required region is secured.

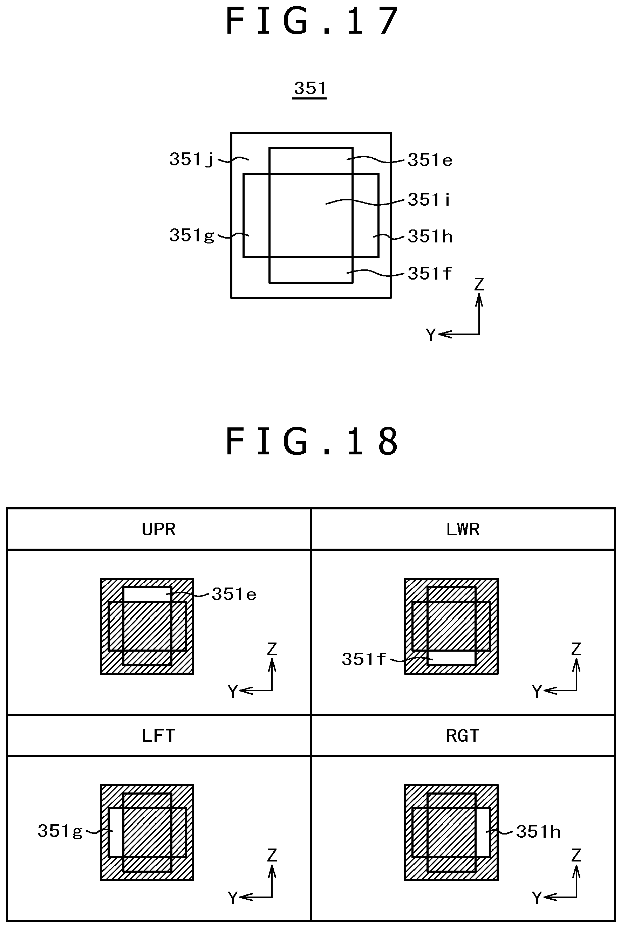

An illumination device 35 according to a third modification is described referring to Fig 17. Fig. 17 is an explanatory view of the irradiation regions of the plane emission type lighting according to the third modification of the first embodiment. Fig. 18 is a view of the irradiation regions for irradiating illumination light of the plane emission type lighting as shown in Fig. 17.

Except the plane emission type lighting 351, the illumination device 35 of the third modification has the similar structure to that of the illumination device 35 according to the first embodiment.

The irradiation region of the plane emission type lighting 351 is divided for each side surface of the die D to be photographed. As Fig. 17 shows, the plane emission type lighting 351 is divided into four regions corresponding to the mirrors 311a to 311d, respectively. The mirrors 311a to 311d are irradiated with illumination light from the regions 351e to 351h, respectively. As Fig. 18 shows, the regions for irradiating the illumination light are selected from the regions 351e to 351h. The regions 351e, 351f do not irradiate the side surface to be photographed with illumination light, but irradiate the upper surface to be photographed with illumination light.

The region 351e irradiates the side surface of the die D opposite to the mirror 311a with illumination light for photographing as indicated by UPR of Fig. 18.

The region 351f irradiates the side surface of the die D opposite to the mirror 311b with illumination light for photographing as indicated by LWR of Fig. 18.

The region 351g irradiates the side surface of the die D opposite to the mirror 311c with illumination light for photographing as indicated by LFT of Fig. 18.

The region 351h irradiates the side surface of the die D opposite to the mirror 311d with illumination light for photographing as indicated by RGT of Fig. 18.

The four side surfaces of the die D are photographed four times. All the regions 351e to 351h irradiate the upper surface of the die D with illumination light for photographing.

### [Second Embodiment]

Except the intermediate stage section 30, a die bonder according to a second embodiment has the similar structure to that of the die bonder of the first embodiment.

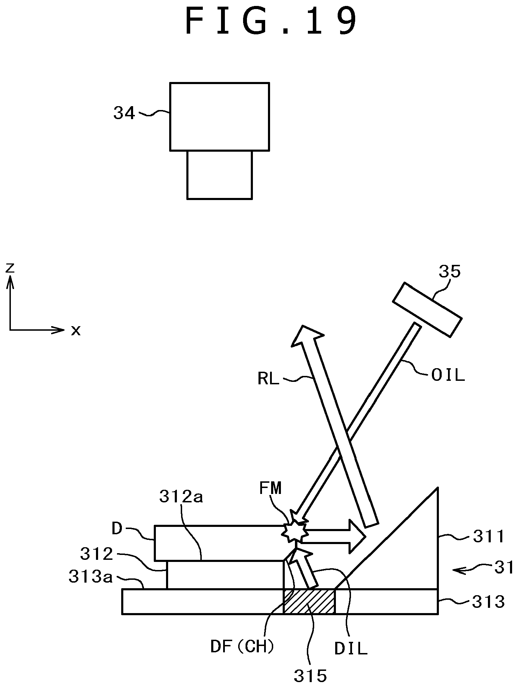

The structure of the intermediate stage section 30 according to the second embodiment is described in detail referring to Fig. 19. Fig. 19 shows a stage recognition camera, an illumination device, and an intermediate stage of the die bonder according to the second embodiment.

The illumination device 35 is an oblique illumination provided above the die D to be irradiated with illumination light OIL, which is inclined at a predetermined angle to the optical axis of the stage recognition camera 34. The side surface of the die D is irradiated with the illumination light OIL. The light reflected by the side surface of the die D is reflected by the mirror 311. The resultant reflected light RL reaches the stage recognition camera 34. This makes it possible to conduct the dark-field type inspection using features of the oblique illumination to the side surface of the die D. The dark-field type makes the background darkened to brightly project an object required to be observed.

The illumination device 35 allows the rough surface owing to the foreign substance or the flaw to be brightly projected, and further to cause white floating. The flaw may be the crack, scratch, chipping, and the like. If the foreign substance and the flaw are not distinguished, they are collectively called abnormality herein. Fig. 19 illustrates an example that the foreign substance FM and the chipping CH exist on the side surface of the die D.

As Figs. 1 and 2 show, the intermediate stage 31 includes four mirrors 311, the stand 312, and the base 313. As Fig. 19 shows, the base 313 includes the illumination section 315 formed at least between the mirror 311 and the stand 312. Fig. 19 shows a part of the intermediate stage 31, for example, only one of the mirrors 311. The illumination device 35 and the illumination section 315 are provided corresponding to the four mirrors 311. For example, the illumination device 35 is constituted by four oblique bar illumination units. The upper surface of the stand 312 may be formed into a polygonal shape, for example, rectangular shape, octagonal shape, and the like, circular shape, or elliptical shape. The intermediate stage is configured so that a mount surface 312a on which the die D on the stand 312 is mounted is higher than an upper surface (stage surface) 313a of the base 313 on which the mirror 311 is placed.

The illumination section 315 has a light emitting surface for diffusively emitting light toward the upper surface (stage surface) 313a of the base 313. Referring to Fig. 19, the flaw DF at a lower side surface of the die D is irradiated with diffusive light DIL from the illumination section 315 as the oblique illumination light. The light reflected by the flaw DF at the lower side surface of the die D is reflected by the mirror 311. The resultant reflected light RL reaches the stage recognition camera 34.

Referring to Fig. 19, the foreign substance FM at an upper side surface of the die D is irradiated with oblique illumination light OIL. The light reflected by the foreign substance FM is then reflected by the mirror 311. The resultant reflected light RL reaches the stage recognition camera 34.

The die D with the flaw DF is regarded as a defective product. The die D with the foreign substance FM may be regarded as a non-defective product depending on the size of the foreign substance. The die with the foreign substance FM having its size equal to or larger than a predetermined value is only regarded as the defective product, for example. This makes it possible to improve the yield. In most cases, the foreign substance FM which adheres to the side surface of the die D may be a fiber waste or a DAF piece, and is projected as the linear blob, or the blob with high aspect ratio in the image. The foreign substance FM has a similar shape to that of the flaw DF. Accordingly, it is difficult to distinguish between the foreign substance FM and the flaw DF.

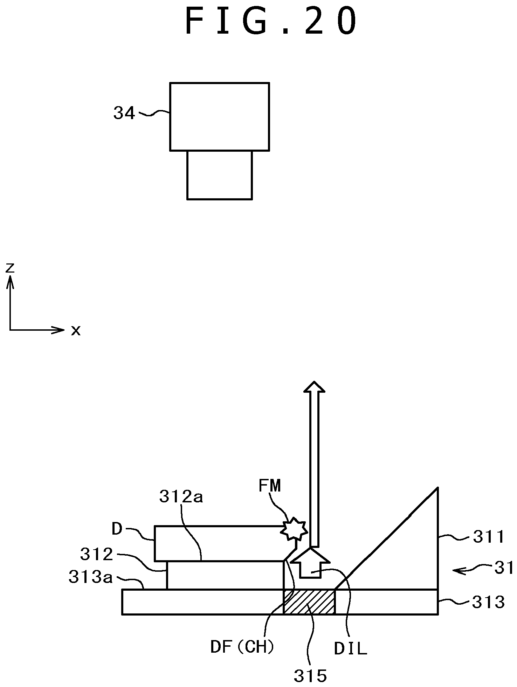

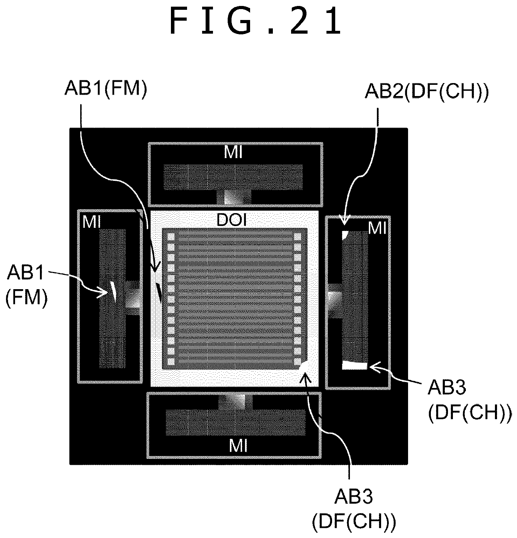

Referring to Figs. 20 and 21, the method of distinguishing between the foreign substance FM and the flaw DF is described. Fig. 20 is a conceptual diagram explaining direct photographing on the intermediate stage as shown in Fig. 19. Fig. 21 is a view of an exemplified image photographed by the structure as shown in Fig. 19.

As described above, each existence of the foreign substance FM and the flaw DF is confirmed in the process as described below. The side surface of the die D is irradiated with the illumination light OIL from the illumination device 35 and the illumination section 315. The light reflected by the foreign substance FM or the flaw DF on the side surface of the die D is reflected by the mirror 311. The resultant reflected light RL is photographed by the stage recognition camera 34. That is, the stage recognition camera 34 photographs a mirror image MI of the side surface of the die D, which is projected on the mirror 311.

The foreign substance FM forms a protruding part of the side surface of the die D, and the flaw DF forms a recess part of the side surface of the die D. Instead of the mirror image MI projected on the mirror 311, the region directly viewed by the stage recognition camera 34 is observed. That is, the stage recognition camera 34 photographs a direct observation image DOI in the region on the upper surface of the die D, and around the outer side of the die D (between the die D and the mirror 311).

The region around the outer side of the die D is observed almost horizontally from the side surface of the die D. Accordingly, the recess part cannot be observed, but only the protruding part can be observed. As Fig. 20 shows, a shadowed outline of the foreign substance FM as the protruding part can be detected by the light irradiated from the illumination section 315 as the transmitted light. Through the detection as described above, if the shadowed outline can be detected at the direct observation position, the abnormality detected by the mirror image MI is identified as the foreign substance FM. Otherwise, the abnormality is identified as the flaw DF.

Referring to the left mirror image MI as shown in Fig. 21, an abnormality AB1 on the side surface of the die D appears white. As the abnormality AB1 appears black in the direct observation image DOI corresponding to the abnormality AB1, the shadowed outline is detected. Accordingly, it is determined that the abnormality AB1 is identified as the foreign substance FM.

Referring to the upper side of the right mirror image MI as shown in Fig. 21, an abnormality AB2 on the side surface of the die D appears white. As there is no abnormality shown in the direct observation image DOI corresponding to the abnormality AB2, the shadowed outline is not detected. Accordingly, it is determined that the abnormality AB2 is identified as the flaw DF (chipping CH).

Referring to the lower side of the right mirror image MI as shown in Fig. 21, an abnormality AB3 on the side surface of the die D appears white. As the abnormality AB3 appears white in the direct observation image DOI corresponding to the abnormality AB3, the shadowed outline is not detected. Accordingly, it is determined that the abnormality AB3 is identified as the flaw DF (chipping CH).

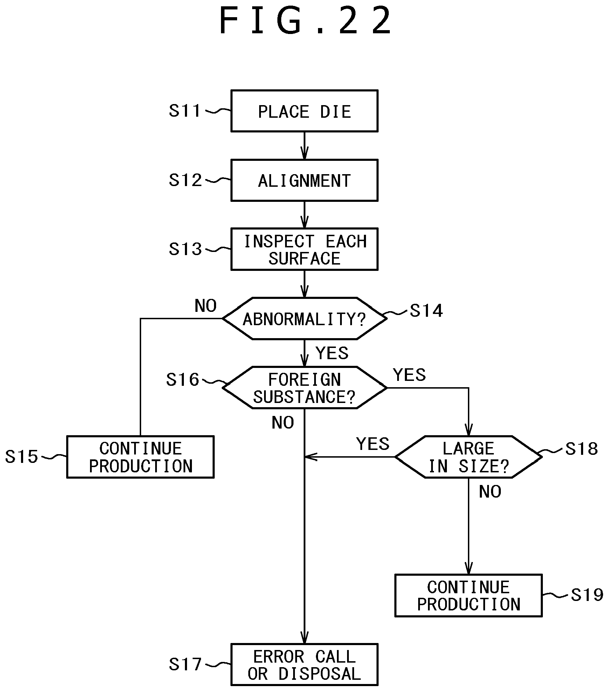

Referring to Fig. 22, the operation flow is described. Fig. 22 is a flowchart representing the surface inspection process for recognizing the foreign substance or the flaw, which has been distinguished. As described below, operations of the respective components constituting the die bonder 1 are controlled by the control section 80.

### (Die place : step S11)

The pick-up head 21 mounts (places) the die D on the stand 312 of the intermediate stage 31.

### (Alignment: step S12)

The stage recognition camera 34 photographs the die D. Based on the photographed image, the control section 80 confirms a posture of the die D. If deviation in the posture (rotational deviation in the horizontal plane) is found, the intermediate stage 31 aligns the die D to correct the deviation.

### (Inspection of each surface : step S13)

The stage recognition camera 34 photographs each surface of the die D (upper surface and four side surfaces). Based on the photographed images, the control section 80 conducts inspection. The respective surfaces may be photographed either simultaneously or individually.

### (Determination of abnormality : step S14)

The control section 80 determines whether any abnormality exists in the mirror image MI as shown in Fig. 21.

### (Continue production : step S15)

If there is no abnormality (NO is obtained), the control section 80 continues production (execute the bond process).

### (Distinguishment between foreign substance and flaw : step S16)

If there is an abnormality (YES is obtained), the control section 80 determines whether the abnormality is identified as the foreign substance FM or the flaw DF.

### (Error call or disposal : step S17)

If it is determined that the abnormality is identified as the flaw (NO is obtained), the control section 80 does not execute the process of bonding the die having the flaw DF, and dumps the die as waste. The control section 80 skips the process to the step of picking up the next die, or issues an error call to stop the production.

### (Determination of size : step S18)

If it is determined that the abnormality is identified as the foreign substance FM (YES is obtained), the control section 80 determines whether the size of the foreign substance FM is equal to or larger than a predetermined value.

### (Continue production : step S19)

If it is determined that the size of the foreign substance FM is smaller than the predetermined value (NO is obtained), the control section 80 continues the production (execute the bond process).

If it is determined that the size of the foreign substance FM is equal to or larger than the predetermined value (YES is obtained), the process proceeds to step S17.

At least one of advantageous effects as described below is derived from the second embodiment.
(a) It is possible to detect the foreign substance and the flaw of the side surface of the die, and to distinguish between the foreign substance and the flaw.
(b) The die with a flaw is handled as a defective product. The die with a foreign substance may be handled as a non-defective product depending on the size. It is possible to perform a substantially accurate defective determination of the product in accordance with the state of side surface of the die. This makes it possible to improve the yield.
(c) It is possible to execute the steps (a) and (b) by photographing at a time, resulting in high-speed operation.
(d) It is possible to execute processing of the four side surfaces by photographing at a time, resulting in high-speed operation.

### <Modification of the second embodiment>

Representative modifications of the second embodiment are described. In the description of the modification, structures, and functions of the components, which are similar to those described in the second embodiment are followed by the similar reference signs. Description of those components allows citation of the corresponding components described in the second embodiment appropriately so long as they are mutually technically consistent. The above-described embodiment and multiple modifications may be partially or entirely applied multifunctionally so long as they are mutually technically consistent.

### (First modification)

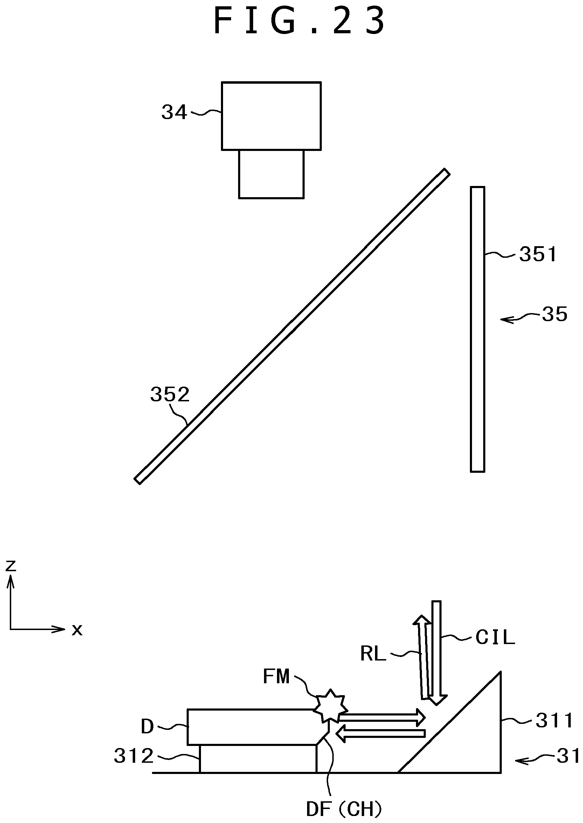

Referring to Fig. 23, the intermediate stage, and the illumination device of a first modification are described. Fig. 23 is a view of the stage recognition camera, the illumination device, and the intermediate stage according to the first modification of the second embodiment.

The illumination device 35 is placed between the stage recognition camera 34 and the intermediate stage 31. The illumination device 35 is formed as a coaxial episcopic illumination (coaxial illumination) which includes the plane emission type lighting (light source) 351 and the half mirror 352. The illumination light from the plane emission type lighting 351 is reflected by the half mirror 352 along the same optical axis as that of the stage recognition camera 34 so that a photograph target on the intermediate stage 31 is irradiated. The resultant scattered light for irradiating the photograph target along the same optical axis as that of the stage recognition camera 34 is reflected by the photograph target. Regular reflected light of the reflected scattered light transmits the half mirror 352, and reaches the stage recognition camera 34 to form an image of the photograph target.

The mirror 311 with a reflection surface inclined by an angle of approximately 45° to the optical axis of the stage recognition camera 34 is placed on the intermediate stage 31. The illumination light CIL from the illumination device 35 is then reflected by the mirror 311. The side surface of the die D is irradiated with the reflected illumination light substantially vertically. The light reflected by the side surface of the die D is reflected by the mirror 311. The resultant reflected light RL reaches the stage recognition camera 34. That is, it is possible to illuminate and take an image of the side surface of the die D substantially vertically. It is possible to execute the inspection of bright-field type which exhibits the feature of the coaxial illumination. In the bright-field type inspection, the background is brightened to observe the target object in the darkened state.

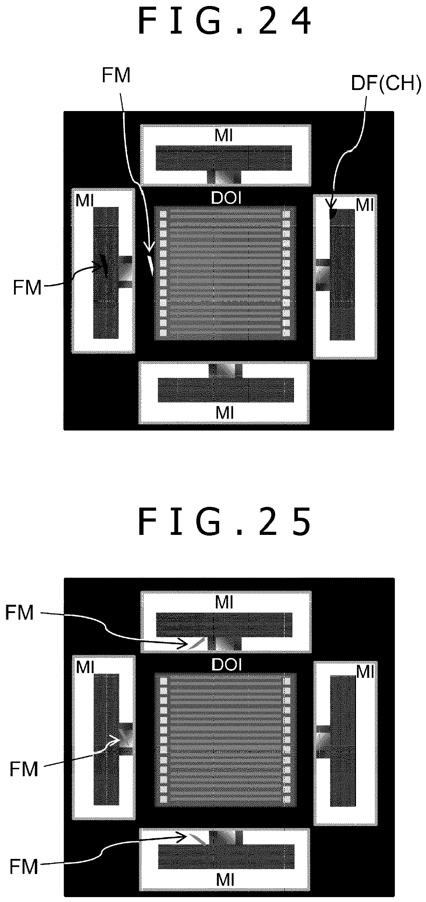

Referring to Figs. 23 to 25, the method for distinguishing between the foreign substance FM and the flaw DF is described. Fig. 24 is a view of an exemplified image photographed by the structure as shown in Fig. 23. Fig. 25 is a view of another exemplified image photographed by the structure as shown in Fig. 23.

As Figs. 24 and 25 show, the use of the illumination device 35 makes the foreign substance FM and the flaw DF which form the rough surface darker than the peripheral region, resulting in black floating of the foreign substance FM and the flaw DF. As Fig. 25 shows, the use of the coaxial illumination together with the transmitted light allows detection of the shadowed outline of the foreign substance FM protruding downward from the back surface of the die D. This makes it possible to photograph a silhouette image.

As Fig. 23 shows, each existence of the foreign substance FM and the flaw DF is confirmed in the process as described below. The side surface of the die D is irradiated with the illumination light CIL from the illumination device 35, which has been reflected by the mirror 311. The light reflected by the foreign substance FM or the flaw DF of the side surface of the die D is reflected by the mirror 311. The resultant reflected light RL is photographed by the stage recognition camera 34. That is, the stage recognition camera 34 photographs the mirror image MI of the side surface of the die D, which is projected on the mirror 311.

The foreign substance FM forms a protruding part of the side surface of the die D, and the flaw DF forms a recess part of the side surface of the die D. Instead of the mirror image MI projected on the mirror 311, the region directly viewed by the stage recognition camera 34 is observed. Specifically, like the embodiment, the stage recognition camera 34 photographs the direct observation image DOI in the region of the upper surface and periphery of the outer side of the die D (between the die D and the mirror 311) besides the mirror image MI.

The region around the outer side of the die D is observed almost horizontally from the side surface of the die D. Accordingly, the recess part cannot be observed, but only the protruding part can be observed. As Fig. 24 shows, outline of the foreign substance FM as the protruding part can be detected in the bright field using the irradiation light from the illumination device 35 as back illumination for the die. If the outline at the direct observation position can be detected by the abnormality detected by the mirror image MI in the bright field, such abnormality is identified as the foreign substance FM. Otherwise, the abnormality is identified as the flaw DF.

### (Second modification)

In the embodiment, the direct observation is conducted to detect the shadowed outline of the foreign substance FM as the protruding part using the illumination light from the illumination section 315 as the transmitted light. The intermediate stage section of a second modification has the structure similar to that of the embodiment. However, the method of detecting the foreign substance FM is different from the one described in the embodiment.

In the second modification, like the first modification, outline of the foreign substance FM as the protruding part can be detected in the bright field using the illumination device 35 as back illumination for the die. In this case, the control section 80 relatively dims or turns off (OFF) the illumination section 315. In the second modification, distinguishment of abnormality is made using the feature as described below. That is, if an outline of the abnormality detected by the mirror image MI can be detected at the direct observation position in the bright field, such abnormality is identified as the foreign substance FM. Otherwise, the abnormality is identified as the flaw DF.

### (Third modification)

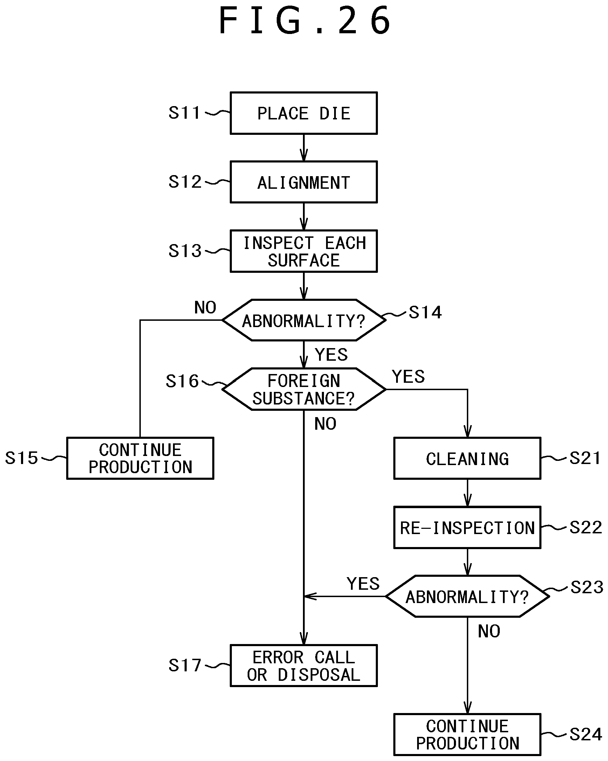

In the embodiment, if the size of the foreign substance FM is equal to or larger than the predetermined value, the die is handled as the defective product. If the foreign substance FM is removed from such die, it can be produced as the non-defective product. In a third modification, if the abnormality is identified as the foreign substance FM, the process of removing the foreign substance is executed. Referring to Fig. 26, the operation flow of the process is described. Fig. 26 is a flowchart of the surface inspection process according to the third modification of the second embodiment for recognizing the foreign substance or the flaw, which has been distinguished.

Steps S11 to S17 of the third modification are executed similarly to steps S11 to S17 in the embodiment.

### (Cleaning : step S21)

In step S16, if the abnormality is identified as the foreign substance FM (YES is obtained), the control section 80 executes cleaning of the die D. Upon cleaning, an air discharge/suction nozzle is provided in the vicinity to execute the process of removing the foreign substance FM.

### (Re-inspection : step S22)

The control section 80 executes the inspection similarly to the one executed in step S13.

### (Abnormality determination : step S23)

The control section 80 executes the abnormality determination similarly to the one executed in step S14.

### (Continue production : step S24)

If there is no abnormality (NO is obtained), the control section 80 continues production (execute the bond process). If the foreign substance FM exists (YES is obtained), the control section 80 proceeds the process to step S17.

The disclosure has been described in detail based on the embodiments (first and the second embodiments), and modifications of those embodiments. It is to be understood that the disclosure is not limited to the embodiments and modifications, but may be variously modified.

In the embodiment, the mirrors are provided on the intermediate stage, and the die is mounted between those mirrors. The use of the stage such as the intermediate stage is not necessarily required. The mirror may be provided at the position opposite to the side surface of the die. The mirror may be fixed using a support or the like, and the fixed die is transported to the position between the mirrors while being held by the collet of the pick-up head or the bond head so that the side surface inspection is conducted. In the above-described case, the oblique illumination device is used in place of the illumination section 315 in the second embodiment.

In the embodiment, the die bonder has been described as below. That is, the die is picked up by the pick-up head from the die supply section, and mounted on the intermediate stage. The die mounted on the intermediate stage is picked up by the bonding head, and bonded to the substrate. Bonding may be performed without using the pick-up head. Specifically, the die is picked up by the bonding head from the die supply section, and mounted on the intermediate stage. The die mounted on the intermediate stage is picked up by the bonding head, and bonded to the substrate.

In the embodiment, the DAF is attached to the back surface of the wafer. The DAF, however, is not necessarily required.

In the embodiment, the die is bonded while having its upper surface directed upward. It is also possible to bond the die which has been turned upside-down after the pick-up operation so that the lower surface is directed upward. The device used for implementing the process is called the flip-chip bonder.

In the example according to the embodiment, the die is picked up from the wafer of the die supply section. The die may be picked up from the tray.

The die bonder has been described in the example according to the embodiment. However, it is applicable to the chip mounter (surface mounter) for placing the electronic part and the semiconductor chip on the wiring substrate.

In the example according to the second embodiment, the illumination section 315 has the light emitting surface for diffusively emitting light to the upper surface (stage surface) 313a of the base 313. The illumination section 315, however, may be constituted by a light guide plate without limitation to the above-described structure. The back illumination may be replaced by a diffusive reflecting member placed at a part corresponding to the illumination light emission surface (back illumination) of the embodiment so that the illumination device irradiates the member with parallel light. The illumination device may irradiate a fluorescent diffusion sheet with ultraviolet light, which is placed at a part corresponding to the illumination light emission surface (back illumination) of the embodiment.

It is possible to replace a part of the structure of one embodiment with the structure of another embodiment or modification thereof. The one embodiment may be provided with an additional structure of another embodiment or modification thereof. It is further possible to add, remove, and replace the other structure to, from and with a part of the structure of the respective embodiments.

### <Supplementary description>

Preferred modes of the present disclosure are described.

### (Supplementary description 1)

A mounting device includes a mirror placed to face a side surface of a die, an imaging device provided so that the die and a reflection surface of the mirror are positioned in the field of view, and a control device for causing the imaging device to photograph a mirror image which passes through the reflection surface of the mirror, and a direct observation image of a region between the side surface of the die and the mirror without intervention of the mirror, and determining that the abnormality detected by the mirror image is identified as the foreign substance if the outline is detected at the direct observation position, and that the abnormality is identified as the flaw if the outline is not detected.

### (Supplementary description 2)

The mounting device as described in the supplementary description 1 further includes a first illumination device disposed above the die, and a second illumination device placed below the die. The mirror image is generated by illumination light irradiated from the first and the second illumination devices. The direct observation image is generated by the illumination light irradiated from the second illumination device.

### (Supplementary description 3)

The mounting device as described in the supplementary description 2 further includes an intermediate stage having a base on which the mirror is placed, and a stand attached to the base. The base is provided with the second illumination device.

### (Supplementary description 4)

The mounting device as described in the supplementary description 1 further includes a first illumination device disposed obliquely upward to the die, and a second illumination device disposed obliquely downward to the die. The mirror image is generated by illumination light irradiated from the first and the second illumination devices. The direct observation image is generated by illumination light irradiated from the first illumination device.

### (Supplementary description 5)

The mounting device as described in the supplementary description 4 further includes an intermediate stage having a base on which the mirror is placed, and a stand attached to the base. The base is provided with the second illumination device.

### (Supplementary description 6)

The mounting device as described in the supplementary description 1 further includes an illumination device for irradiating illumination light along an optical axis of the imaging device. The mirror image is generated by the illumination light irradiated from the illumination device. The direct observation image is generated by the illumination light irradiated from the illumination device.

### (Supplementary description 7)

The mounting device as described in the supplementary description 6 further includes an intermediate stage having a base on which the mirror is placed, and a stand attached to the base.

### (Supplementary description 8)

In the mounting device as described in any one of the supplementary descriptions 1 to 7, if the abnormality is identified as a flaw, the control section determines that the die is defective. If the abnormality is identified as a foreign substance, the control section determines that the die is defective when a size of the abnormality exceeds a predetermined value, and determines that the die is non-defective when the size of the abnormality is equal to or smaller than the predetermined value.

### (Supplementary description 9)

In the mounting device as described in any one of the supplementary descriptions 1 to 7, if the abnormality is identified as a flaw, the control section determines that the die is defective. If the abnormality is identified as a foreign substance, the control section executes an abnormality removing process. If the foreign substance cannot be removed, the control section determines that the die is defective. If the foreign substance can be removed, the control section determines that the die is non-defective.

### (Supplementary description 10)

A method of manufacturing a semiconductor device includes a step of loading a wafer to a mounting device provided with a mirror placed to face a side surface of a die, and an imaging device provided so that the die and a reflection surface of the mirror are positioned in the field of view. The method further includes a step of causing the imaging device to photograph a mirror image which passes through the reflection surface of the mirror, and a direct observation image of a region between the side surface of the die and the mirror without intervention of the mirror. In the step, if an outline of the abnormality detected by the mirror image can be detected at the direct observation position, the abnormality is identified as a foreign substance. If the outline cannot be detected, the abnormality is identified as a flaw.

### Reference Signs List

1: die bonder (mounting device)
311: mirror
34: recognition camera (imaging device)
35: illumination device
D: die

## Claims

1. A mounting device, comprising:
at least paired mirrors disposed to face with each other;
an imaging device disposed to have a die and a reflection surface of the mirror positioned in a field of view;
an illumination device for irradiating illumination light along an optical axis of the imaging device; and
a blurring suppressing unit for suppressing blurring generated on an outline of a side surface of the die by a part of the light reflected by the reflection surface of one of the paired mirrors, the part of the light passing through a periphery of the die.

2. The mounting device according to claim 1, wherein the blurring suppressing unit is formed to function as a surrounding light suppressing unit for preventing the part of the light reflected by the reflection surface of one of the paired mirrors, which has passed through the periphery of the die from reaching the imaging device.

3. The mounting device according to claim 2, wherein:
the surrounding light suppressing unit is formed as the paired mirrors, each having the reflection surface disposed obliquely to the optical axis of the imaging device at a predetermined angle larger than 45°; and
the predetermined angle is set to allow photographing of the side surface of the die, and to prevent the light passing through the periphery of the die from reaching the imaging device.

4. The mounting device according to claim 2, wherein:
the surrounding light suppressing unit is formed as the paired mirrors, each having the reflection surface disposed obliquely to the optical axis of the imaging device at a predetermined angle smaller than 45°; and
the predetermined angle is set to allow photographing of the side surface of the die, and to prevent the light passing through the periphery of the die from reaching the imaging device.

5. The mounting device according to claim 2, wherein:
the surrounding light suppressing unit includes a first polarized filter attached to an upper part of one of the paired mirrors, and a second polarized filter attached to an upper part of the other of the paired mirrors; and
a polarizing direction of the first polarized filter is different from a polarizing direction of the second polarized filter by 90°.

6. The mounting device according to claim 2, further comprising a stage, wherein:
the paired mirrors are disposed on an upper surface of the stage;
the imaging device is provided above the stage; and
the stage includes the surrounding light suppressing unit.

7. The mounting device according to claim 1, wherein the blurring suppressing unit includes an irradiation suppressing unit for suppressing the light from irradiating the reflection surface of one of the paired mirrors.

8. The mounting device according to claim 7, wherein:
the irradiation device includes a plane emission type lighting; and
the irradiation suppressing unit divides an irradiation region of the plane emission type lighting into multiple regions to allow one of the multiple irradiation regions of the plane emission type lighting to irradiate one of the side surfaces of the die, and to prevent the others from irradiating the other side surface of the die.

9. The mounting device according to claim 8, wherein the irradiation suppressing unit is a shielding plate which is moved to select the irradiation region of the plane emission type lighting.

10. The mounting device according to claim 8, wherein the irradiation suppressing unit is a light-off region of the plane emission type lighting to select the irradiation region by switching between a light-on region and the light-off region of the plane emission type lighting.

11. The mounting device according to claim 7, further comprising a stage, wherein:
the paired mirrors are disposed on an upper surface of the stage;
the imaging device is provided above the stage; and
the stage includes the irradiation suppressing unit.

12. A method of manufacturing a semiconductor device, comprising the steps of:
loading a wafer to a mounting device which includes at least paired mirrors disposed to face with each other, an imaging device disposed to have a die and a reflection surface of the mirror positioned in a field of view, an
illumination device for irradiating illumination light along an optical axis of the imaging device, and a blurring suppressing unit for suppressing blurring generated on an outline of a side surface of the die by a part of the light reflected by the reflection surface of one of the paired mirrors, which has passed through a periphery of the die; and
photographing the side surface of the die by the imaging device.
